# EUROPEAN PATENT APPLICATION

(11) **EP 3 477 511 A1**
(43) Date of publication of application: **01.05.2019**
(21) Application number: 18184082.8
(22) Date of filing: 18.07.2018
(51) Int. Cl.: G06F 17/50

(54) **SIMULATION METHOD, SIMULATION APPARATUS, AND PROGRAM**

(30) Priority: 24.10.2017 JP 2017204856
(71) Applicant: Sumitomo Heavy Industries, Ltd., Tokyo 141-6025 (JP)
(72) Inventor: MATSUMURA, Yuya, Yokosuka-shi,, Kanagawa 237-8555, (JP)
(74) Representative: Louis Pöhlau Lohrentz

(57) **Abstract**

Provided is a simulation method capable of reducing a computation load in simulation for a motion of a rigid body and behaviors of a plurality of particles interacting with the rigid body.

Rotational movement of a rigid body around a central axis and behaviors of a plurality of particles in an analysis region in which the rigid body is accommodated are simulated, the rigid body having a shape which is rotationally symmetric with respect to the central axis. First, the analysis region is divided into two regions by using two half-planes with the central axis as a boundary, and one region is defined as a partial analysis region. A signed distance function representing the shape of the rigid body is generated on the basis of the shape of the rigid body. A periodic boundary condition is applied such that faces of the partial analysis region corresponding to the half-planes have periodicity with respect to a rotation direction with the central axis as the rotation center, and behaviors of the rigid body and the plurality of particles inside the partial analysis region are obtained by using the signed distance function through simulation in the partial analysis region.

## Description

### BACKGROUND OF THE INVENTION

### Field of the Invention

A certain embodiment of the present invention relates to a simulation method, a simulation apparatus, and a program, capable of performing coupled analysis of motion of a rigid body and behaviors of a plurality of particles.

Priority is claimed to Japanese Patent Application No. 2017-204856, filed October 24, 2017, the entire content of which is incorporated herein by reference.

### Description of Related Art

In simulation using a particle method such as a molecular dynamics method (MD method), a technique is generally employed in which a rigid body is represented by a plurality of particles, and a behavior of each particle is analyzed (for example, Japanese Patent No. 6098190). For example, if a shape of a rigid body is complex, the number of particles representing the rigid body increases, and thus a computation load increases.

In the particle method, generally, a periodic boundary condition is applied to a system which is assumed to have periodicity with respect to three directions orthogonal to each other of an orthogonal coordinate system. In a case where a shape of a rigid body does not have periodicity with respect to the three directions orthogonal to each other, such a periodic boundary condition cannot be applied.

### SUMMARY OF THE INVENTION

It is desirable to provide (An object of the present invention is to provide) a simulation method, a simulation apparatus, and a program capable of reducing a computation load in simulation of a motion of a rigid body and behaviors of a plurality of particles interacting with the rigid body.

According to an aspect of the present invention, there is provided a simulation method of simulating rotational movement of a rigid body around a central axis and behaviors of a plurality of particles in an analysis region in which the rigid body is accommodated, the rigid body having a shape which is rotationally symmetric with respect to the central axis, the simulation method including: dividing the analysis region into two regions by using two half-planes with the central axis as a boundary, and defining one region as a partial analysis region; generating a signed distance function representing the shape of the rigid body on the basis of the shape of the rigid body; and applying a periodic boundary condition such that faces of the partial analysis region corresponding to the half-planes have periodicity with respect to a rotation direction with the central axis as the rotation center, and obtaining behaviors of the rigidbody and the plurality of particles inside the partial analysis region by using the signed distance function through simulation in the partial analysis region.

According to another aspect of the present invention, there is provided a simulation apparatus including: a processing device that simulates rotational movement of a rigidbody around a central axis and behaviors of a plurality of particles in an analysis region in which the rigid body is accommodated, the rigid body having a shape which is rotationally symmetric with respect to the central axis, in which the processing device divides the analysis region into two regions by using two half-planes with the central axis as a boundary on the basis of shape data in a case where the shape data for defining the shape of the rigid body is input from an input device, and defines one region as a partial analysis region, generates a signed distance function representing the shape of the rigid body on the basis of the shape data, applies a periodic boundary condition such that periodicity is obtained with respect to a rotation direction with the central axis as the rotation center, and obtains behaviors of the rigid body and the plurality of particles inside the partial analysis region by using the signed distance function through simulation in the partial analysis region, and outputs a simulation result to an output device.

According to still another aspect of the present invention, there is provided a program causing a computer to realize a function of simulating rotational movement of a rigid body around a central axis and behaviors of a plurality of particles in an analysis region in which the rigid body is accommodated, the rigid body having a shape which is rotationally symmetric with respect to the central axis, the program causing the computer to realize: a function of dividing the analysis region into two regions by using two half-planes with the central axis as a boundary, and defining one region as a partial analysis region; a function of applying a periodic boundary condition such that faces of the partial analysis region corresponding to the half-planes have periodicity with respect to a rotation direction with the central axis as the rotation center; a function of generating a signed distance function representing the shape of the rigid body on the basis of the shape of the rigid body; and a function of simulating behaviors of the rigid body and the plurality of particles inside the partial analysis region by using the signed distance function in the partial analysis region.

It is possible to reduce a computation load in simulation for a motion of a rigid body and behaviors of a plurality of particles interacting with the rigid body.

### BRIEF DESCRIPTION OF THE DRAWINGS

Fig. 1 is a perspective view illustrating examples of simulation targets in a simulation method according to an embodiment.
Figs. 2A and 2B are sectional views perpendicular to a central axis of the simulation target.
Fig. 3 is a schematic diagram for explaining a signed distance function (SDF) defining a shape of a rigid body.
Fig. 4 is a block diagram illustrating a simulation apparatus according to the embodiment.
Fig. 5 is a flowchart illustrating a simulation method according to the embodiment.
Fig. 6A is a graph illustrating a temporal change in angular velocity obtained through simulation, and Fig. 6B is a graph illustrating time required for computation.

### DETAILED DESCRIPTION OF THE INVENTION

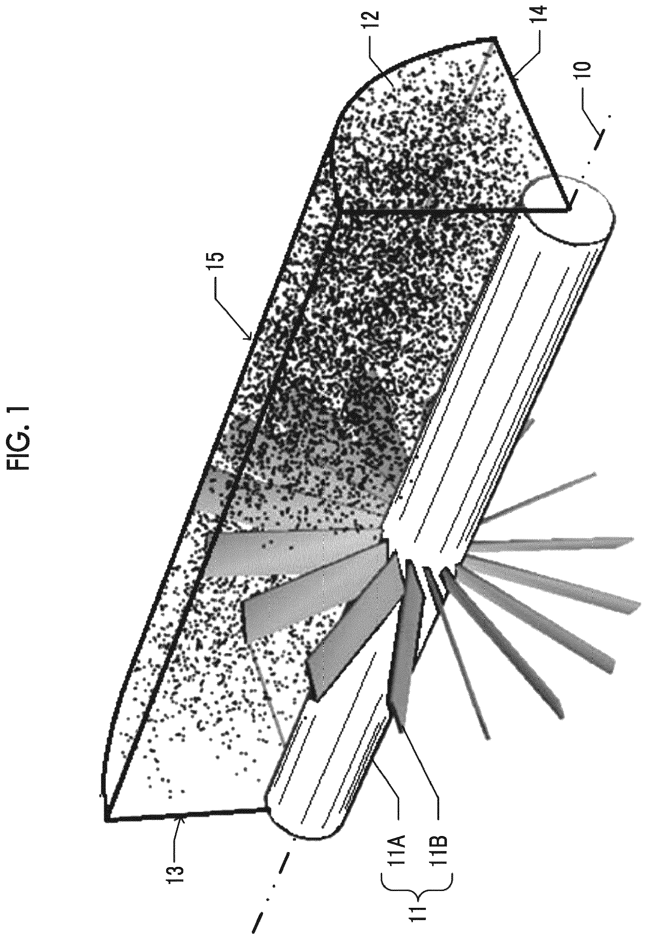

With reference to Fig. 1, a description will be made of a simulation target in a simulation method according to an embodiment.

Fig. 1 is a perspective view illustrating examples of simulation targets in a simulation method according to an embodiment. Simulation targets are a rigid body 11 which is rotationally symmetric with respect to a central axis 10, and a plurality of particles 12 corresponding to a fluid in a space (analysis region) in which the rigid body is accommodated. In other words, in the embodiment, coupled analysis of the rigid body and the fluid is performed. In the simulation, rotational movement of the rigid body 11 and behaviors of the plurality of particles 12 are obtained. The rigid body 11 as a simulation target illustrated in Fig. 1 is configured with a columnar rotation shaft 11A and a plurality of rotor blades 11B protruding in a radial direction from a side surface of the rotation shaft 11A. In a case where the number of rotor blades 11B is indicated by n, the rigid body 11 is rotationally symmetric n times around the central axis 10. Here, n is an integer of 2 or greater.

In the simulation according to the embodiment, an analysis region is divided into a plurality of regions with two half-planes 13 and 14 with the central axis 10 as a boundary, and one region is defined as a partial analysis region 15. A section of the partial analysis region 15 perpendicular to the central axis 10 has a fan shape. Calculation of the simulation is performed in the partial analysis region 15. In a case where a shape of the rigid body 11 and the analysis region have n times rotational symmetry (where n is an integer of 2 or greater) with respect to the central axis 10, the half-planes 13 and 14 are defined such that an angle formed by the two half-planes 13 and 14 is an integer multiple of 360°/n.

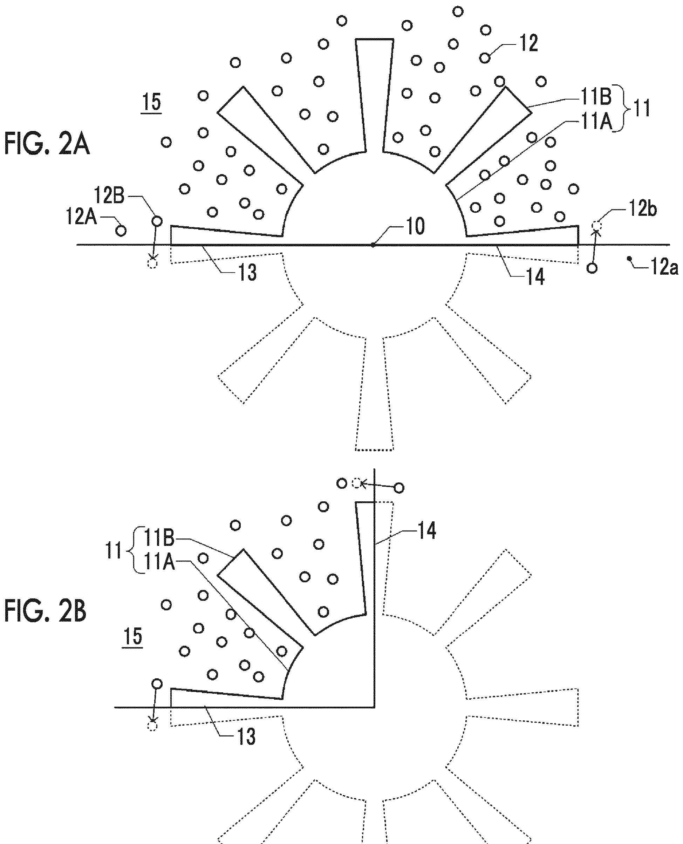

A periodic boundary condition is defined such that boundaries of the partial analysis region 15 corresponding to the half-planes 13 and 14 have periodicity with respect to a rotation direction with the central axis 10 as the rotation center. The periodic boundary condition will be described later with reference to Figs. 2A and 2B. For example, a reflectance boundary condition is applied to a boundary corresponding to a circular portion with the fan-shaped section of the partial analysis region 15.

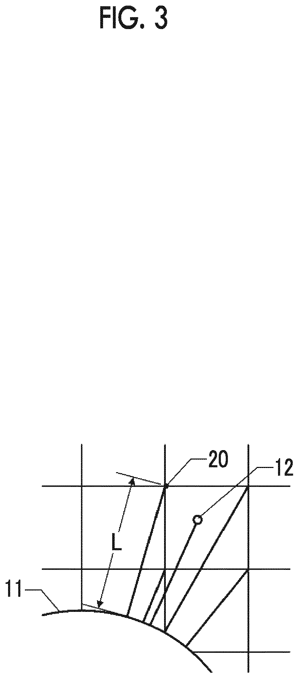

A shape of the rigid body 11 is represented by a signed distance function (SDF) representing a shape of the rigid body 11. A distance between the rigid body 11 and the particle 12 is calculated on the basis of the SDF and a coordinate of the particle 12. The SDF will be described later with reference to Fig. 3.

Next, with reference to Fig. 2A, the periodic boundary condition will be described.

Fig. 2A is a sectional view perpendicular to the central axis 10. Fig. 2A illustrates an example in which the rotor blades 11B are eight. An example is illustrated in which an angle (central angle) formed between the two half-planes 13 and 14 is 180 degrees. In the example illustrated in Fig. 2A, the upper half of the figure is defined as the partial analysis region 15, and simulation calculation is performed on the rigid body 11 and behaviors of the particles 12 in the partial analysis region 15. For example, a molecular dynamics method is applied to the simulation calculation.

Calculation is performed on a particle 12A located around the boundary of the partial analysis region 15, that is, the half-planes 13 and 14 by taking into consideration interaction between the particle 12 present around a rotationally symmetric position 12a with respect to a position of the particle 12A and the rigid body 11. In a case where a particle 12B crosses the periodic boundary and moves to the outside of the partial analysis region 15, a particle 12b crosses the periodic boundary and advances to a position which is rotationally symmetric to the position after the particle 12B moves.

As illustrated in Fig. 2B, an angle formed between the two half-planes 13 and 14 may be 90 degrees. In this case, periodic boundaries of the partial analysis region 15 intersect each other with an angle of 90 degrees. In other words, a central angle of the partial analysis region 15 is 90 degrees. The periodic boundary condition is applied to two boundaries corresponding to the half-planes 13 and 14. As illustrated in Figs. 2A and 2B, in a case where the rigid body 11 has eight times rotational symmetry, a central angle of the partial analysis region 15 may be 45 degrees.

Next, a description will be made of an SDF generated on the basis of the shape of the rigid body 11 (Fig. 1) with reference to Fig. 3.

Fig. 3 is a schematic diagram for explaining an SDF. Three-dimensional orthogonal lattices are disposed around the rigid body 11. The shortest distance L from each lattice point (node) 20 of the orthogonal lattices to the rigidbody is calculated front obstacle each lattice point 20. The shortest distance L calculated for each lattice point 20 is an SDF. When the lattice point 20 is located outside the rigid body 11, a sign of the shortest distance L is defined to be positive, and, when the lattice point 20 is located inside the rigid body 11, a sign of the shortest distance L is defined to be negative.

A distance from the particle 12 to the rigid body 11 may be calculated by performing interpolation calculation on the basis of an SDF value (the shortest distance L from a vertex to the rigid body 11) of the vertex of a cell of the orthogonal lattices in which the particle 12 is present.

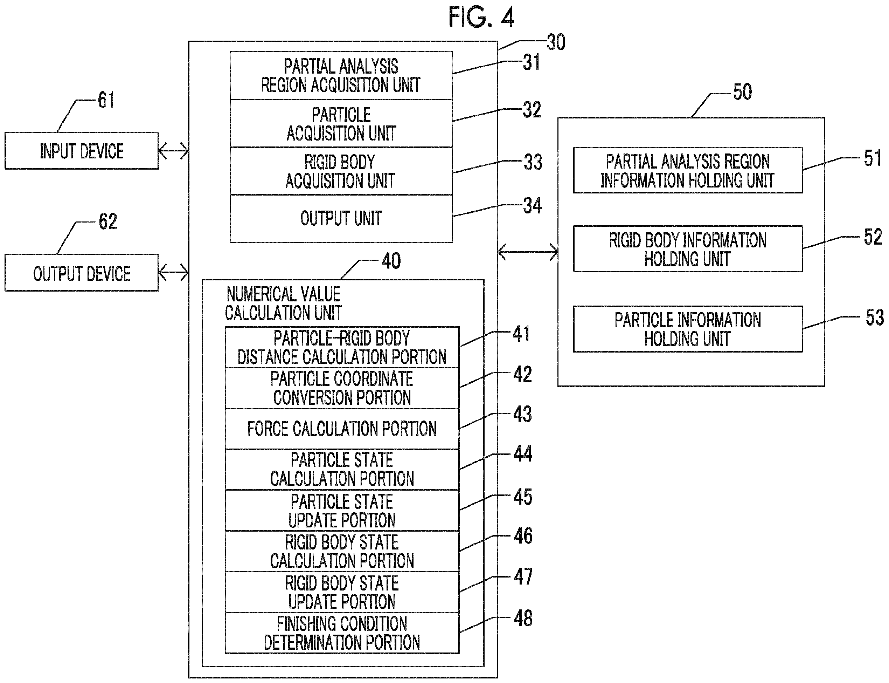

Next, with reference to Fig. 4, a description will be made of a simulation apparatus according to the embodiment.

Fig. 4 is a block diagram illustrating a simulation apparatus according to the embodiment. The simulation apparatus according to the embodiment includes a processing device 30, a storage device 50, an input device 61, and an output device 62. The processing device 30 is realized by a central processing unit (CPU) or the like of a computer in hardware, and a function of each block is realized by the CPU executing a computer program.

The processing device 30 is connected to the storage device 50, the input device 61, and the output device 62. The input device 61 receives various pieces of data related to a process performed by the processing device 30 from a user. As the input device 61, for example, a keyboard, a pointing device, a reading device for removable media, or a communication device may be used. As the output device 62, for example, an image display device, a writing device writing data to removable medium, or a communication device may be used. The processing device 30 outputs information such as a simulation result to the output device 62.

The processing device 30 includes a partial analysis region acquisition unit 31, a particle acquisition unit 32, a rigid body acquisition unit 33, an output unit 34, and a numerical value calculation unit 40. The storage device 50 includes a partial analysis region information holding unit 51, a rigid body information holding unit 52, and a particle information holding unit 53.

The partial analysis region acquisition unit 31 acquires information for dividing an analysis region and defining the partial analysis region 15 (Fig. 1) via the input device 61. The partial analysis region acquisition unit 31 registers information for expressing the acquired partial analysis region 15 in a virtual space, in the partial analysis region information holding unit 51. The information for expressing the partial analysis region 15 in a virtual space includes a function representing a plane, a curved surface, a straight line, and a curved line, and includes, especially, information indicating the central axis 10 and the half-planes 13 and 14 (Fig. 1).

The particle acquisition unit 32 acquires information for defining a particle system of a simulation target from the user via the input device 61. The information for defining the particle system includes information for defining the number of particles 12 (Fig. 1) and a position and a velocity of each particle. The particle acquisition unit 32 registers each particle 12 in the particle information holding unit 53 in correlation with a position and a velocity thereof.

The rigid body acquisition unit 33 acquires shape data for defining a shape of the rigid body 11 (Fig. 1) from the user via the input device 61. An SDF is generated with respect to a portion located in the partial analysis region 15 (Fig. 1) on the basis of the shape data, and is registered in the rigid body information holding unit 52.

The output unit 34 outputs a simulation result to the output device 62. In addition, information of which the user is to be notified, for example, information for prompting the user to input data is output to the output device 62.

Next, a description will be made of a function of each block of the numerical value calculation unit 40.

A particle-rigid body distance calculation portion 41 calculates a distance from the particle 12 to the rigid body 11 on the basis of the current position of the particle 12 (Fig. 1) and an SDF defining a shape of the rigid body 11 (Fig. 1).

A particle coordinate conversion portion 42 converts a coordinate of the particle 12 in correspondence to rotation of the rigid body 11. Specifically, a coordinate of the particle 12 is converted instead of rotating the rigid body 11 in a virtual space in which the rigid body 11 and the particle 12 are disposed. Consequently, a relative positional relationship between the rigid body 11 and the particle 12 is equivalent to a relative positional relationship of when the rigid body 11 is rotated in the virtual space.

A force calculation portion 43 calculates force acting between the particles 12 and force acting between the particle 12 and the rigid body 11. An interaction potential between the particles 12 and a potential applied to the peripheral particles 12 from the rigid body 11 are used for calculation of the force. For example, a Leonard-Jones potential may be used as the potentials.

A particle state calculation portion 44 obtains a state after one time step elapses from the current state on the basis of a motion equation with respect to each of the plurality of particles 12 (Fig. 1). A state of the particle 12 includes a position and a velocity thereof.

A particle state update portion 45 updates a state of each particle 12. Specifically, a state of the particle 12 obtained by the particle state calculation portion 44 is set to the current state of the particle 12, and is registered in the particle information holding unit 53. In a case where an updated position of the particle 12 crosses the periodic boundary of the partial analysis region 15 (Fig. 1) and moves to the outside thereof, the position is returned to the inside of the partial analysis region 15 by applying the periodic boundary condition. Specifically, a position vector and a velocity vector of the particle 12 moved to the outside of the partial analysis region 15 are rotated by the same angle as the central angle of the partial analysis region 15 with the central axis 10 (Fig. 1) as the rotation center.

A rigid body state calculation portion 46 obtains a state of the rigid body 11 after one time step elapses from the current state of the rigid body 11 (Fig. 1) on the basis of a motion equation. The state of the rigid body 11 includes a rotational speed of the rigid body 11 with the central axis 10 (Fig. 1) as the rotation center, and a rotation angle from a reference position.

A rigid body state update portion 47 updates a state of the rigid body 11. Specifically, a state of the rigid body 11 obtained by the rigid body state calculation portion 46 is set to the current state of the rigid body 11, and the state of the rigid body 11 is registered in the rigid body information holding unit 52.

A finishing condition determination portion 48 determines whether or not the simulation process is finished. For example, in a case where calculation is performed for a predefined number of time steps, the simulation process is finished.

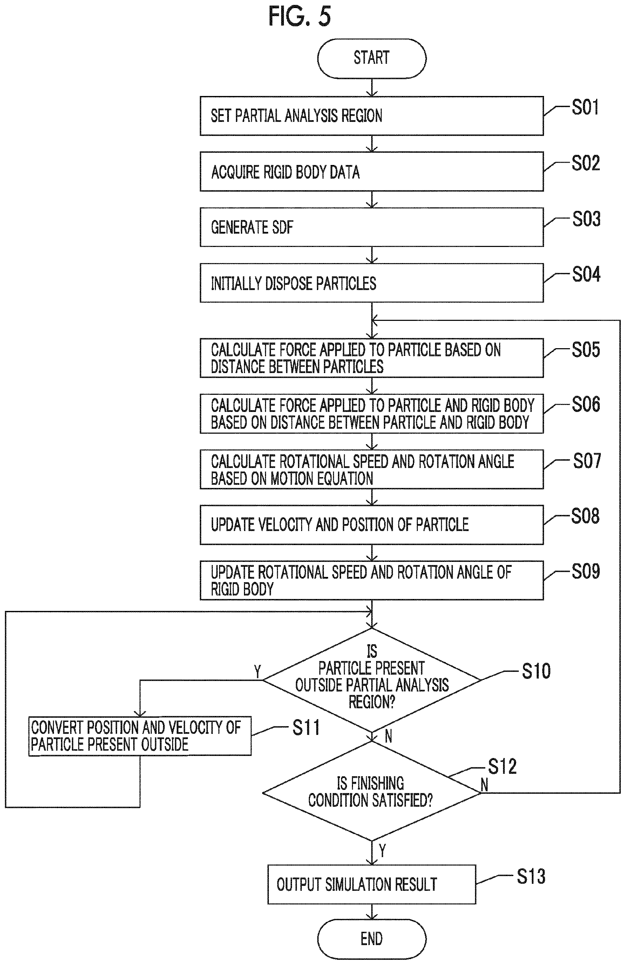

Next, with reference to Fig. 5, a description will be made of a simulation method according to the embodiment.

Fig. 5 is a flowchart illustrating a simulation method according to the embodiment. First, the partial analysis region acquisition unit 31 acquires information regarding the partial analysis region 15 (Fig. 1), and registers the information in the partial analysis region information holding unit 51 (step S01). The rigid body acquisition unit 33 acquires information for defining a shape of the rigid body 11 (Fig. 1) (step S02) . The rigid body acquisition unit 33 generates an SDF on the basis of the acquired information, and registers the SDF in the rigid body information holding unit 52 (step S03).

The particle acquisition unit 32 acquires an initial state of the particle 12, and registers the initial state in the particle information holding unit 53 (step S04). The initial state of the particle 12 includes an initial position and an initial velocity of the particle 12. The mass of the particle 12 is also acquired. The force calculation portion 43 obtains force applied to each particle 12 on the basis of a distance between the particles (step S05). The particle-rigid body distance calculation portion 41 obtains a distance between the particle and the rigid body for each particle 12, and the force calculation portion 43 obtains force applied to the particle 12 and the rigid body 11 on the basis of the distance between the particle and the rigid body (step S06).

The rigid body state calculation portion 46 solves a motion equation on the basis of the force applied to the rigid body 11 and an inertial moment of the rigid body 11 by using the current rotational speed and rotation angle of the rigid body 11 as initial values, and thus obtains a rotational speed and a rotation angle of the rigid body 11 after one time step elapses (step S07).

The particle state calculation portion 44 solves a motion equation on the basis of the force applied to the particle 12 and the mass of the particle 12 by using the current position and velocity of each particle 12 as initial values, and thus obtains a position and a velocity of the particle 12 after one time step elapses. The particle coordinate conversion portion 42 converts coordinates of the position and the velocity of each particle 12 on the basis of the rotation angle of the rigid body 11. The position and the velocity of the particle 12 are updated (step S08). Specifically, a position and a velocity of the particle 12 obtained through the coordinate conversion are set to the current state of the particle 12.

The rigid body state update portion 47 updates the rotational speed and the rotation angle of the rigid body 11 (step S09). Specifically, the rotational speed and the rotation angle of the rigid body 11 obtained in step S07 are set to the current state of the rigid body 11.

The particle state update portion 45 determines whether or not the particle 12 is present outside the partial analysis region 15 (step S10). In a case where the particle 12 is present outside the partial analysis region 15, the periodic boundary condition is applied to the particle 12 outside the partial analysis region 15, so as to convert a position and a velocity thereof (step S11). Step S11 is executed on all particles 12 present outside the partial analysis region 15.

The finishing condition determination portion 48 determines whether or not a finishing condition is satisfied (step S12). In a case where the finishing condition is not satisfied, the process from step S05 is repeatedly performed. In a case where the finishing condition is satisfied, the output unit 34 outputs a simulation result to the output device 62 (step S13) .

Next, excellent effects of the simulation method according to the embodiment will be described.

According to the embodiment, the rigid body 11 (Fig. 1) is not represented by an aggregate of a plurality of particles, but a shape thereof is represented by using an SDF. Thus, a calculation load is reduced compared with a case where calculation is performed on a plurality of particles forming the rigid body 11 one by one.

In the present embodiment, the analysis region is divided focusing on rotational symmetry of the rigid body 11, and calculation is performed with respect to the partial analysis region 15. Thus, a calculation load is reduced compared with a case where calculation is performed with respect to the entire analysis region.

In the present embodiment, in a case where the rigid body 11 is rotated in a virtual space in which the rigid body 11 and a plurality of particles 12 are disposed, coordinate conversion is performed on a position and a velocity of the particle 12 instead of regenerating an SDF for defining a shape of the rigid body 11. Since an SDF is not required to be regenerated according to rotation of the rigid body 11, a calculation load required to generate an SDF is reduced.

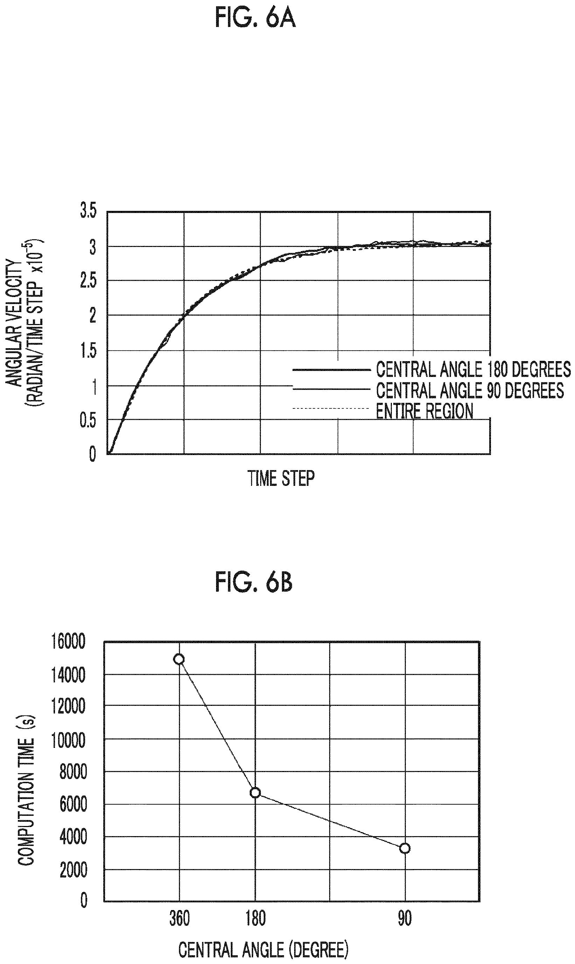

In order to check an effect of the simulation method according to the embodiment, simulation was actually performed. Next, with reference to Figs. 6A and 6B, a simulation result will be described. In the simulation, a windmill-shaped rotation rigid body was provided in a flow field, and a temporal change in angular velocity of the rigid body due to action from a fluid was obtained. The number of time steps in the simulation was about one hundred thousand, and the number of particles in the entire analysis region was about thirty-two thousand. A Leonard-Jones potential was used as an interaction potential.

Fig. 6A is a graph illustrating a temporal change in angular velocity obtained through the simulation. A transverse axis expresses elapsed time (the number of time steps) in a dimensionless manner, and a longitudinal axis expresses angular velocity in the unit of "radian/time step".

A thick solid line and a thin solid line in the group of Fig. 6A respectively indicate simulation results in cases where a central angle of the partial analysis region 15 (Fig. 1) was set to 180 degrees and 90 degrees . A result in which the simulation was performed on the entire analysis region is indicated by a dashed line for reference.

As illustrated in Fig. 6A, a significant difference was not found between a case where the simulation was performed on the entire analysis region and a case where the simulation was performed on the partial analysis region 15 which is cut out from the entire analysis region.

Fig. 6B is a graph illustrating time required for computation. A transverse axis expresses a central angle of the partial analysis region 15 (Fig. 1) in the unit of "degree", and a longitudinal axis expresses computation time in the unit of "second". Simulation of when a central angle is 360 degrees corresponds to a case where the entire analysis region is a simulation target. It can be seen that computation time is shortened as the central angle of the partial analysis region 15 is reduced.

As illustrated in Fig. 6A, it is confirmed that sufficient simulation accuracy can be obtained even if simulation is performed on the partial analysis region 15 (Fig. 1) which is cut out from the entire analysis region. As illustrated in Fig. 6B, it is confirmed that computation time can be reduced by performing simulation on the partial analysis region 15.

Next, modification examples of the embodiment will be described.

In the above-described embodiment, the rigid body 11 (Fig. 1) configured with the rotation shaft 11A and the rotor blade 11B is used as a simulation target rigid body, but rigid bodies formed in various shapes having n times rotational symmetry (where n is an integer of 2 or greater) may be used as simulation targets. In the above-described embodiment, a molecular dynamics method is applied to simulation for behaviors of the rigid body 11 and the particle 12, but other particle methods, for example, a renormalized molecular dynamics method (RMD method), a discrete element method (DEM method), an SPH method, or an MPS method may be used.

The embodiment and the modification examples are only examples, partial replacement or combination of the configurations described in the embodiment and the modification examples may occur. The same advantageous effects based on the same configurations as those in the embodiment and the modification examples are not sequentially described in the embodiment and the modification examples. The present invention is not limited to the embodiment and the modification examples. For example, it is clear to a person skilled in the art that various alterations, modifications, combinations, and the like may occur.

### Brief Description of the Reference Symbols

10: central axis
11: rigid body
11A: rotation shaft
11B: rotor blade
12: particle
12A: particle around periodic boundary
12a: rotationally symmetric position to position of particle around periodic boundary
12B: particle moving to outside of partial analysis region by crossing periodic boundary
12b: particle advancing to rotationally symmetric position to position after particle 12B moves
13, 14: half-plane
15: partial analysis region
20: node of orthogonal lattice for defining SDF
30: processing device
31: partial analysis region acquisition unit
32: particle acquisition unit
33: rigid body acquisition unit
34: output unit
40: numerical value calculation unit
41: particle-rigid body distance calculation portion
42: particle coordinate conversion portion
43: force calculation portion
44: particle state calculation portion
45: particle state update portion
46: rigid body state calculation portion
47: rigid body state update portion
48: finishing condition determination portion
50: storage device
51: partial analysis region information holding unit
52: rigid body information holding unit
53: particle information holding unit
61: input device
62: output device

## Claims

1. A simulation method of simulating rotational movement of a rigid body around a central axis and behaviors of a plurality of particles in an analysis region in which the rigid body is accommodated, the rigid body having a shape which is rotationally symmetric with respect to the central axis, the simulation method comprising:
dividing the analysis region into two regions by using two half-planes with the central axis as a boundary, and defining one region as a partial analysis region;
generating a signed distance function representing the shape of the rigid body on the basis of the shape of the rigid body; and
applying a periodic boundary condition such that faces of the partial analysis region corresponding to the half-planes have periodicity with respect to a rotation direction with the central axis as the rotation center, and obtaining behaviors of the rigid body and the plurality of particles inside the partial analysis region by using the signed distance function through simulation in the partial analysis region.

2. The simulation method according to claim 1, wherein the shape of the rigid body, the behavior of the rigid body, and the analysis region have n times rotational symmetry (where n is an integer of 2 or greater) with respect to the central axis, and an angle formed between the two half-planes is a multiple of 360°/n.

3. The simulation method according to claim 1 or 2, wherein a molecular dynamics method is applied to simulation for the behaviors of the particles.

4. A simulation apparatus comprising:
a processing device that simulates rotational movement of a rigid body around a central axis and behaviors of a plurality of particles in an analysis region in which the rigid body is accommodated, the rigid body having a shape which is rotationally symmetric with respect to the central axis,
wherein the processing device
divides the analysis region into two regions by using two half-planes with the central axis as a boundary on the basis of shape data in a case where the shape data for defining the shape of the rigid body is input from an input device, and defines one region as a partial analysis region,
generates a signed distance function representing the shape of the rigid body on the basis of the shape data,
applies a periodic boundary condition such that periodicity is obtained with respect to a rotation direction with the central axis as the rotation center, and obtains behaviors of the rigid body and the plurality of particles inside the partial analysis region by using the signed distance function through simulation in the partial analysis region, and
outputs a simulation result to an output device.

5. The simulation apparatus according to claim 4, wherein the shape of the rigid body, the behavior of the rigid body, and the analysis region have n times rotational symmetry (where n is an integer of 2 or greater) with respect to the central axis, and the processing device defines the partial analysis region such that an angle formed between the two half-planes is a multiple of 360°/n.

6. The simulation apparatus according to claim 4 or 5, wherein the processing device applies a molecular dynamics method to simulation for the behaviors of the particles.

7. A program causing a computer to realize a function of simulating rotational movement of a rigid body around a central axis and behaviors of a plurality of particles in an analysis region in which the rigid body is accommodated, the rigid body having a shape which is rotationally symmetric with respect to the central axis, the program causing the computer to realize:
a function of dividing the analysis region into two regions by using two half-planes with the central axis as a boundary, and defining one region as a partial analysis region;
a function of applying a periodic boundary condition such that faces of the partial analysis region corresponding to the half-planes have periodicity with respect to a rotation direction with the central axis as the rotation center;
a function of generating a signed distance function representing the shape of the rigid body on the basis of the shape of the rigid body; and
a function of simulating behaviors of the rigid body and the plurality of particles inside the partial analysis region by using the signed distance function in the partial analysis region.
